# FASCICULE DE BREVET EUROPEEN

(11) **EP 3 840 072 B1**
(45) Date de publication et mention de la délivrance du brevet: **21.05.2025**
(21) Numéro de dépôt: 20215698.0
(22) Date de dépôt: 18.12.2020
(51) Int. Cl.: C23C 28/00, C23C 28/04, C23C 14/02, C23C 14/06, C23C 14/32, H01L 33/32, H01L 21/02, H10N 30/079, H10N 30/00, H01L 33/00, H01L 33/12

(54) **PROCEDE DE FABRICATION D'UNE COUCHE DE NITRURE D'ALUMINIUM TEXTURE**
VERFAHREN ZUR HERSTELLUNG EINER TEXTURIERTEN ALUMINIUMNITRID-SCHICHT
METHOD FOR MANUFACTURING A LAYER OF TEXTURED ALUMINIUM NITRIDE

(30) Priorité: 20.12.2019 FR 1915272
(43) Date de publication de la demande: 23.06.2021
(73) Titulaire: Commissariat à l'Energie Atomique et aux Energies Alternatives, 75015 Paris (FR)
(72) Inventeur: CADOT, Stéphane, 38054 GRENOBLE Cedex 09 (FR); MARTIN, François, 38054 GRENOBLE Cedex 09 (FR); GASSILOUD, Rémy, 38054 GRENOBLE Cedex 09 (FR)
(74) Mandataire: Brevalex

(56) Documents cités:
- WO-A1-2019/168187
- CN-A- 107 086 175

## Description

### DOMAINE TECHNIQUE

La présente invention telle que définie par les revendications se rapporte au domaine général des couches minces d'AIN texturé.

L'invention concerne un procédé pour fabriquer une telle couche.

L'invention concerne également un empilement susceptible d'être obtenu par le procédé.

L'invention est particulièrement intéressante puisqu'elle permet de fabriquer une couche d'AIN hautement texturé sans avoir besoin d'utiliser un substrat monocristallin.

L'invention trouve des applications dans de nombreux domaines industriels, et notamment dans le domaine de la microélectronique et de l'électronique.

### ÉTAT DE LA TECHNIQUE ANTÉRIEURE

Les matériaux à base d'un nitrure de la colonne 13 du tableau périodique (notamment AIN, GaN, InN ainsi que leurs composés ternaires) présentent des propriétés particulièrement intéressantes (notamment de bonnes propriétés piézoélectriques). Depuis quelques années, ils font l'objet de nombreuses recherches et trouvent des applications dans divers domaines tels que l'électronique de puissance, les dispositifs radiofréquences (RF) ou encore les diodes électroluminescentes.

Dans le domaine des dispositifs RF, c'est une couche mince piézoélectrique de nitrure d'aluminium (AlN) qui est utilisée pour convertir les ondes acoustiques en signal électrique. Afin d'obtenir des performances élevées, cette couche d'AIN doit être cristallisée sous sa forme wurtzite (maille hexagonale), orientée (002) et hautement texturée (c'est-à-dire constituée de cristaux rigoureusement orientés dans la même direction). Elle doit donc être déposée à haute température en utilisant des substrats d'épitaxie tel que le saphir monocristallin (α-Al₂O₃) ou le carbure de silicium hexagonal (6H-SiC).

Or, la mise en œuvre de tels procédés et/ou l'utilisation de tels substrats posent des problèmes de compatibilité avec les procédés et standards actuels de l'industrie du silicium.

De plus, l'utilisation de substrats monocristallins conduit à des étapes d'intégration compliquées et coûteuses, pouvant nécessiter une étape de décollage (« lift off ») et de transfert de la couche mince d'AIN, ou encore une étape de gravure du substrat monocristallin puis l'intégration des électrodes par la face arrière.

Une autre méthode consiste à déposer directement la couche mince d'AIN sur une électrode pouvant induire une orientation préférentielle dans le plan 002 des cristaux d'AIN. De telles électrodes peuvent être, par exemple, en molybdène polycristallin orienté (110) ou en platine orienté (111).

Cependant, la taille des cristaux et leur orientation doivent être maîtrisées de manière à être reproductibles, et la texture des couches minces obtenues sur ces électrodes polycristallines n'est pas aussi bonne que celle obtenue sur des substrats de saphir ou de SiC monocristallins. De plus, la texture de la couche mince d'AIN à proximité de l'électrode est dégradée, et il est nécessaire de former une couche d'AIN de forte épaisseur (typiquement supérieure à 500 nm) de manière à obtenir une texture satisfaisante pour des applications RF. Or, certaines applications, comme la 5G exigent des fréquences plus élevées, nécessitant une réduction de l'épaisseur des couches d'AIN.

Récemment, l'attention s'est tournée vers des matériaux 2D, comme par exemple le graphène, le nitrure de bore hexagonal h-BN et les dichalcogénures de métaux de transition (TMD), en tant que couche de nucléation pour la croissance des nitrures. En particulier, des TMD tels que MoS₂ ou WS₂ sont des matériaux particulièrement prometteurs pour la croissance de GaN et d'AIN puisqu'ils présentent un paramètre de maille proche de ces matériaux (1 à 3%).

Cependant, il est admis que, pour former du GaN ou du AIN hautement cristallin sur des dichalcogénures de métaux de transition, la couche de nucléation de MoS₂ ou WS₂ doit également être hautement cristalline.

Par exemple dans l'article de Gupta et al. (« Layered transition metal dichalcogenides: promising neartattice-matched substrates for GaN growth », Scientific Reports | 6:23708 | DOI: 10.1038/srep23708), la couche de nucléation est obtenue par exfoliation micromécanique à partir de monocristaux de WS₂ ou de MoS₂ suivi d'une étape de transfert de la couche exfoliée sur le substrat de croissance.

Dans l'article de Hsu et al. ("Monolayer MoS2 Enabled Single-Crystalline Growth of AIN on Si(100) Using Low-Temperature Helicon Sputtering », ACS Appl. Nano Mater. 2019, 2, 1964-1969), la croissance de la couche de MoS₂ est réalisée dans un premier temps sur du saphir, par CVD, puis cette couche est transférée sur un substrat de silicium, par l'intermédiaire de poly(méthacrylate de méthyle) (PMMA). Il est indiqué que, après report, le réseau hexagonal hautement orienté de la couche MoS₂ est préservé, ce qui est essentiel pour la croissance ultérieure du film de nitrure.

Dans le document de Ohunchi (« Fabrication of self-supporting AlN Film Subtrates by Van Der Waals Lift-Off », Final Report to Air Force office of Scientific Research 1998), la couche de WS₂ est fabriquée par épitaxie en phase vapeur à l'aide de précurseurs organométalliques (MOCVD) sur substrat monocristallin de silicium. Juste avant le dépôt de la couche de WS₂, le substrat est gravé à l'acide fluorhydrique afin de retirer la couche d'oxyde natif et permettre la croissance épitaxiale du WS₂ sur le silicium (cette stratégie limitant par ailleurs le budget thermique applicable au procédé en raison de la formation de siliciure de tungstène au-delà de 500°C).

Cependant, de tels procédés ne peuvent pas être directement utilisés dans un processus d'intégration de dispositifs sans devoir passer par des étapes coûteuses de transfert ou d'intégration d'électrodes par la face arrière du substrat, voire ne sont pas compatibles avec une production à grande échelle.

Les demandes de brevet CN 107 086 175 A et WO 2019 / 168187 A1 divulgent encore des procédés et des dispositifs connus. Dans ces divulgations, la couche de nucléation n'a pas une orientation aléatoire.

### EXPOSÉ DE L'INVENTION

Un des buts de la présente invention est de remédier aux inconvénients de l'art antérieur et, en particulier, de proposer un procédé de fabrication d'une couche mince d'AIN texturé, de bonne qualité, même pour de faibles épaisseurs, le procédé devant être simple à mettre en œuvre et peu coûteux.

Pour cela, la présente invention propose un procédé de fabrication d'une couche mince d'AIN texturé comprenant les étapes successives suivantes :
a) fourniture d'un substrat ayant une surface amorphe,
b) formation d'une couche de nucléation polycristalline de MS₂ avec M=Mo, W ou un de leurs alliages, sur la surface amorphe du substrat, la couche de nucléation polycristalline étant constituée de domaines cristallins de MS₂ dont les plans de base (002) sont parallèles à la surface amorphe du substrat, les domaines cristallins étant orientés aléatoirement dans un plan (a, b) formé par la surface amorphe du substrat,
c) dépôt de nitrure d'aluminium sur la couche de nucléation de MS₂, conduisant à la formation d'une couche mince d'AIN texturé.

Par aléatoirement, on entend que les domaines cristallins ne sont pas orientés de la même manière dans le plan (a, b). Les domaines cristallins ne présentent pas d'orientation préférentielle.

La couche d'AIN ainsi obtenue présente une structure hexagonale de type wurtzite et croit en suivant l'orientation cristalline de la couche de nucléation pour former des cristaux d'AIN dont les plans 002 sont rigoureusement parallèles à ceux de la couche de nucléation.

Par texturé (ou orienté cristallographiquement), on entend que la couche mince d'AIN est formée d'une multitude de cristaux, tous orientés dans la même direction, au moins à l'échelle de la zone active pour le dispositif visé, et possiblement sur toute la surface du substrat.

La texturation est typiquement évaluée par diffraction des rayons X à l'aide d'une mesure de courbe d'oscillation (« rocking curve ») obtenue en faisant varier la position angulaire omega autour de la position de Bragg du plan 002 de l'AIN. La largeur à mi-hauteur (FWHM) du pic obtenu permet de quantifier la texturation de la couche d'AIN.

Plus la valeur de cette largeur à mi-hauteur est faible, plus la distribution de l'orientation des grains est étroite et plus la qualité cristalline est améliorée : le film est dit texturé.

Par hautement texturé, on entend que la largeur à mi-hauteur de la courbe d'oscillation (« rocking curve ») du plan 002 de l'AIN est inférieure à 2°, de préférence inférieure à 1° et encore plus préférentiellement inférieure à 0,5° pour des couches dont l'épaisseur est supérieure à 50 nm.

L'invention se distingue fondamentalement de l'art antérieur par la croissance de la couche de nitrure d'aluminium sur une couche de MS₂ nanocristalline dont les domaines cristallins sont orientés aléatoirement dans le plan (a, b) formé par la surface du substrat.

Contre toute attente, la présence de cette couche de nucléation nanocristalline et orientée aléatoirement dans le plan (a, b) formé par la surface du substrat permet la croissance d'une couche d'AIN mieux texturée que celle obtenue sur électrode de molybdène 110, et aussi bien texturée que celle obtenue sur des cristaux de MoS₂ de taille micrométrique idéalement formés sur saphir monocristallin et tous orientés dans la même direction.

De manière contre-intuitive, il semble donc que la taille des domaines cristallins constituant la couche de MS₂ ne joue pas un rôle essentiel dans la texture du film d'AIN, et par conséquent que la nucléation de l'AIN n'ait pas lieu au niveau des joints de grains de la couche de MS₂, le caractère aléatoire de la configuration des joints de grains ne permettant pas à priori d'induire une orientation préférentielle des cristaux d'AIN nécessaire à l'obtention d'un film d'AIN texturé.

De plus, une telle couche de MS₂ peut être directement formée sur un substrat amorphe et servir à la fois de couche de nucléation pour l'AIN et de barrière à la gravure, offrant ainsi d'avantage de possibilités dans la stratégie d'intégration.

Avantageusement, l'alliage M de la couche de nucléation de MS₂ contient jusqu'à 50% atomique d'un ou plusieurs éléments additionnels choisis parmi les métaux de transition. Le ou les éléments additionnels sont ajoutés en quantité suffisamment faible pour ne pas impacter de manière critique le paramètre de maille de la couche de nucléation MS₂. Par de manière critique, on entend, ici et par la suite, que le paramètre du réseau cristallin ne variera pas de plus de 0,05 nm selon les axes a et b de manière à ne pas altérer le paramètre de maille de la couche.

Avantageusement, la couche de nucléation de MS₂ a une épaisseur allant de 0,6 nm à 50 nm, et de préférence de 0,6 nm à 8 nm.

Selon une première variante de réalisation avantageuse, l'étape b) est réalisée à une température autorisant la formation d'une couche de nucléation polycristalline de MS₂ en une seule étape.

Selon une deuxième variante de réalisation avantageuse, l'étape b) est réalisée selon les étapes suivantes :
- dépôt d'une couche de MSₓ avec x supérieur ou égal à 2,
- recuit de la couche de MSₓ sous atmosphère inerte à une température allant de 450°C à 1200°C et de préférence de 750°C à 950°C, de manière à former une couche polycristalline de MS₂.

Selon une troisième variante de réalisation avantageuse, l'étape b), pour former une couche de MS₂, est réalisée selon les étapes successives suivantes :
- dépôt d'une couche mince contenant le métal ou l'alliage M sous forme élémentaire (pur), ou associé à un ou plusieurs hétéroatomes (par exemple sous la forme d'un oxyde, d'un nitrure, d'un séléniure ou d'un oxysulfure),
- recuit thermique réactif en présence d'un composé volatil contenant du soufre à une température allant de 150°C à 1200°C et, de préférence, de 350°C à 750°C,
- éventuellement, recuit sous atmosphère inerte à une température allant de 450°C à 1200°C et, de préférence, de 750°C à 950°C, de manière à former une couche de nucléation polycristalline de MS₂.

Selon ces trois variantes de réalisation avantageuses, les couches minces de MS₂, de MSₓ ou celle contenant le métal ou l'alliage M peuvent être déposées, de préférence, par dépôt chimique en phase vapeur (« Chemical Vapor Deposition » ou CVD), par dépôt chimique en phase vapeur par couches atomiques (« Atomic Layer Deposition » ou ALD), par dépôt physique en phase vapeur (PVD pour « Physical Vapor Deposition ») ou par pulvérisation cathodique (« RF sputtering »).

Avantageusement, la couche de nucléation polycristalline de MS₂ contient un élément dopant tel que l'azote, le phosphore, l'arsenic ou l'antimoine. L'élément dopant est ajouté dans des proportions n'induisant pas une altération des paramètres de maille du composé MS₂ supérieure à ±0,05 nm selon les axes a et b.

Avantageusement, l'étape c) de dépôt de la couche mince d'AIN texturé est réalisée par dépôt physique en phase vapeur ou pulvérisation cathodique.

Avantageusement, la couche mince d'AIN texturé a une épaisseur allant de 1 nm à 1 µm.

Avantageusement, la couche mince d'AIN texturé contient des éléments dopants tels que le chrome, le molybdène, le tungstène, le scandium, l'yttrium ou un élément des lanthanides. Les éléments dopants sont introduits dans des proportions n'induisant pas une altération des paramètres de maille de l'AIN supérieure à ±0,05 nm selon les axes a et b.

Avantageusement, la surface amorphe du substrat est faiblement rugueuse. Par faiblement, il est entendu une rugosité inférieure à 5nm, de préférence inférieure à 1 nm, et encore plus préférentiellement inférieure à 0,3 nm.

Selon un mode de réalisation particulier, les étapes b) et c) peuvent être répétées cycliquement de manière à obtenir un empilement comprenant une alternance de couches de nucléation de MS₂ et de couches minces d'AIN texturé.

Selon une première variante de réalisation, le procédé comporte une étape additionnelle, ultérieure à l'étape c), au cours de laquelle on retire un empilement comprenant la couche de nucléation polycristalline MS₂ et la couche mince d'AIN texturé du substrat. Cette étape peut être réalisée, par exemple, en séparant l'empilement du substrat par décollement mécanique (« lift off ») à l'aide d'une couche de transfert.

Selon une autre variante de réalisation, le procédé comporte une étape additionnelle, ultérieure à l'étape c), au cours de laquelle on sépare la couche mince d'AIN texturé du substrat et de la couche de nucléation MS₂.

Ces deux variantes de réalisation peuvent être réalisées par clivage soit à l'interface substrat/couche de nucléation soit à l'interface couche de nucléation/couche mince d'AIN texturé si la couche de nucléation adhère bien au substrat.

Le procédé présente de nombreux avantages :
- être simple à mettre en œuvre,
- ne pas nécessiter l'utilisation de substrats monocristallins,
- permettre la formation d'AIN à structure colonnaire hautement texturé sur substrat amorphe, n'importe quel type de substrat pouvant aisément être rendu amorphe en surface ou recouvert d'une couche mince d'un matériau amorphe,
- permettre une texturation de l'AIN dès les premiers nanomètres déposés et donc l'obtention de couches d'AIN hautement texturé ayant de faibles épaisseurs (typiquement ayant une épaisseur inférieure à 100 nm, voire inférieure à 50 nm),
- pouvoir fonctionner avec des couches de nucléation de MS₂ extrêmement minces qui n'auront que très peu d'incidence sur le fonctionnement du dispositif final,
- être basé sur l'utilisation d'une couche de nucléation stable à l'air et à l'humidité pendant plusieurs mois, et ne nécessitant aucun traitement de surface avant la croissance de la couche d'AIN. Il n'est donc pas nécessaire d'enchainer sous vide le dépôt de la couche de nucléation et celui de la couche d'AIN.

L'invention concerne également un empilement susceptible d'être obtenu par le procédé tel que défini précédemment comprenant, et de préférence constitué successivement par :
- une couche mince d'AIN texturé,
- une couche de nucléation polycristalline de MS₂ avec M=Mo, W ou un de leurs alliages, la couche de nucléation polycristalline étant constituée de domaines cristallins dont les plans de base (002) sont parallèles à l'empilement, l'orientation des domaines cristallins dans un plan (a, b) formé par l'empilement étant aléatoire,
- éventuellement, un substrat possédant une surface amorphe, la couche de nucléation polycristalline de MS₂ étant disposée entre le substrat et la couche mince d'AIN texturé.

La couche mince d'AIN texturé est en contact direct avec la couche de nucléation de MS₂. Autrement dit, il n'y a pas de couche intermédiaire entre les deux couches.

Les caractéristiques liées au procédé se retrouvent également dans l'empilement formé à l'issue du procédé.

L'invention concerne également un dispositif microélectronique, par exemple un dispositif radiofréquence (RF), une LED, un dispositif de puissance ou une membrane piézoélectrique, par exemple une membrane acoustique piézoélectrique, comprenant un empilement tel que défini précédemment.

L'invention concerne également un dispositif microélectronique, par exemple un dispositif radiofréquence (RF), une LED, un dispositif de puissance ou une membrane piézoélectrique comprenant une couche mince d'AIN texturé.

D'autres caractéristiques et avantages de l'invention ressortiront du complément de description qui suit.

Il va de soi que ce complément de description n'est donné qu'à titre d'illustration de l'objet de l'invention et ne doit en aucun cas être interprété comme une limitation de cet objet.

### BRÈVE DESCRIPTION DES DESSINS

La présente invention sera mieux comprise à la lecture de la description d'exemples de réalisation donnés à titre purement indicatif et nullement limitatif en faisant référence aux dessins annexés sur lesquels :

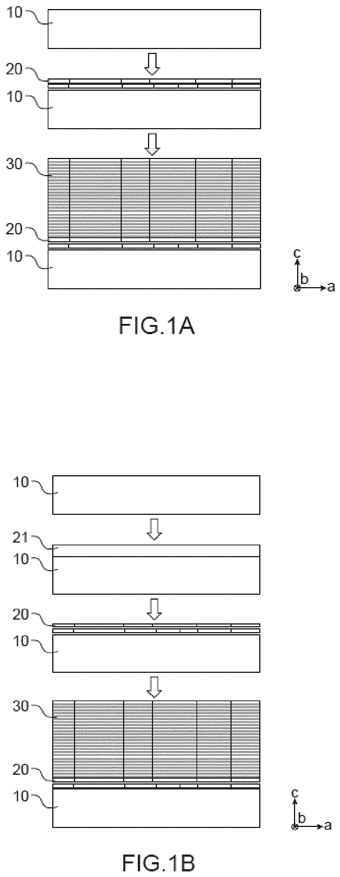

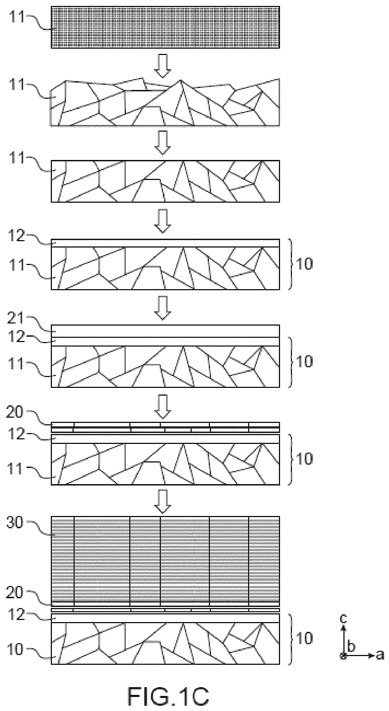

Les figures 1 A , 1B et 1C représentent, de manière schématique, différentes étapes de différents procédés de fabrication d'une couche mince d'AIN texturé selon différents modes de réalisation particuliers de l'invention.

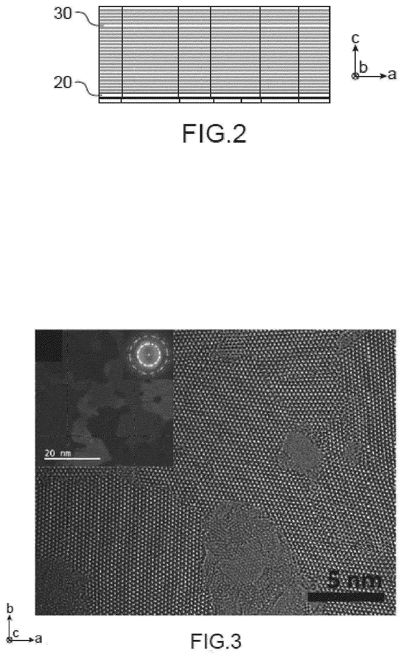

La figure 2 représente, de manière schématique, et en coupe transversale, un empilement formé d'une couche de nucléation polycristalline de MS₂ et d'une couche mince d'AIN texturé, selon un mode de réalisation particulier de l'invention.
La figure 3 est une vue dans le plan obtenue par microscopie électronique en transmission (TEM) d'une couche mince de MoS₂ de 0,6 nm d'épaisseur (une monocouche), obtenue selon un mode de réalisation particulier du procédé selon l'invention, et transférée sur une grille TEM. L'insert est un cliché obtenu par diffraction des électrons avec une cartographie de l'orientation des domaines cristallins,

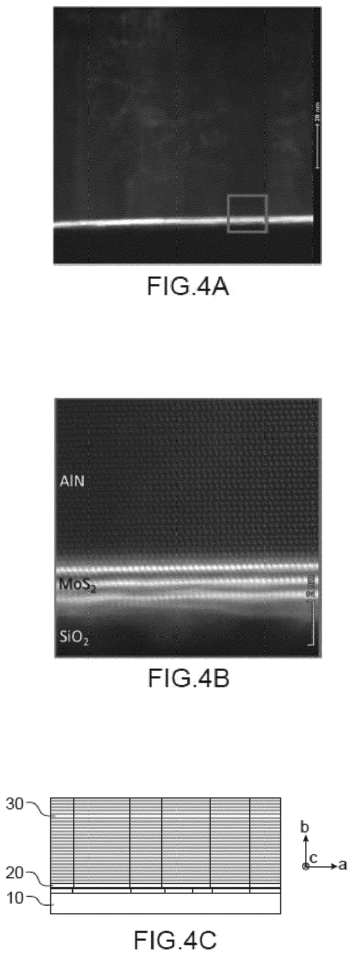

Les figures 4A et 4B sont des clichés obtenus par microscopie électronique en transmission sur une coupe transversale d'un empilement comprenant un substrat amorphe de SiO₂, une couche de nucléation polycristalline de MoS₂ de 2 nm d'épaisseur et une couche d'AIN de 100 nm, à différents facteurs de grossissement.
La figure 4C représente de manière schématique, l'empilement, obtenu selon un mode de réalisation particulier de l'invention, observé sur les figures 4A et 4B.

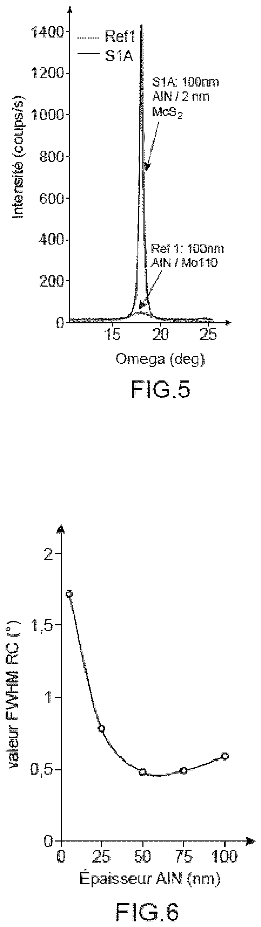

La figure 5 est un graphique représentant les courbes d'oscillation (« rocking curves ») du plan 002 de l'AIN, pour une couche mince d'AIN de 100 nm d'épaisseur déposée sur une couche de nucléation de MoS₂ de 2 nm d'épaisseur selon un mode de réalisation particulier du procédé de l'invention (noté S1a), et pour une couche mince d'AIN de 100 nm d'épaisseur déposée sur un échantillon de référence comprenant une électrode texturée en molybdène orienté 110 (noté Ref1).
La figure 6 est un graphique représentant l'évolution de la largeur à mi-hauteur (FWHM) de la courbe d'oscillation (« rocking curve ») du plan 002 de l'AIN mesuré par diffraction des rayons X pour des échantillons d'AIN de différentes épaisseurs (5 nm à 100 nm) obtenus sur une couche de nucléation de MoS₂ selon un mode de réalisation particulier du procédé de l'invention.

Afin de permettre une meilleure lisibilité, les différentes parties représentées sur les figures ne le sont pas nécessairement à la même échelle.

### EXPOSÉ DÉTAILLÉ DE MODES DE RÉALISATION PARTICULIERS

On se réfère tout d'abord aux figures 1A, 1B, et 1C.

Le procédé de fabrication d'une couche d'AIN texturé comporte au moins les étapes successives suivantes :
a) fourniture d'un substrat 10 ayant une surface amorphe,
b) formation d'une couche de nucléation 20 polycristalline de MS₂ avec M=Mo, W ou un de leurs alliages, sur la surface amorphe du substrat 10, la couche de nucléation polycristalline 20 comprenant des domaines cristallins dont les plans de base (002) sont parallèles à la surface du substrat 10, les domaines cristallins étant orientés aléatoirement dans le plan (a, b) formé par la surface amorphe du substrat 10,
c) dépôt d'AIN sur la couche de nucléation 20, permettant l'obtention d'une couche d'AIN texturée 30.

De préférence, le substrat 10 répond à un ou plusieurs des critères suivants, pris seuls ou en combinaison :
- être amorphe, au moins en surface,
- être thermiquement stable jusqu'à la température la plus élevée du procédé, sans altération de sa rugosité de surface,
- être plan,
- être faiblement rugueux, avec une rugosité moyenne (Rq) avantageusement inférieure à 5nm, de préférence inférieure à 1 nm, et encore plus préférentiellement inférieure à 0,3 nm,
- avoir des propriétés barrière vis-à-vis de la diffusion des éléments constituant la couche de nucléation 20 jusqu'à la température la plus élevée utilisée lors des différentes étapes du procédé.

Selon une première variante de réalisation, le substrat 10 est un matériau amorphe (figures 1A et 1B).

Selon une deuxième variante de réalisation, le substrat 10 comporte un support 11 pouvant être un matériau polycristallin recouvert par une couche mince amorphe 12 (figure 1C).

C'est par exemple le cas lorsque le support 11 est un matériau cristallin s'oxydant spontanément sous air, et à la surface duquel une couche d'oxyde se forme naturellement.

Par exemple, pour un support 11 d'AIN, il se forme spontanément sous air, une couche superficielle d'Al₂O₃ amorphe. Dans le cas du silicium, il se forme spontanément une couche de SiO₂ amorphe.

À titre illustratif, on pourra choisir comme substrat 10 une plaque ou plaquette (« wafer ») de silicium comportant une couche mince superficielle 12 de SiO₂.

Alternativement, il est possible de déposer une couche mince amorphe 12 sur le support 11, de préférence, une couche d'oxyde ou de nitrure restant amorphe à haute température, tel que SiO₂, Al₂O₃ ou SiNₓ. Ce mode de réalisation est avantageux, dans le cas où le support 11 ne s'oxyde pas spontanément sous atmosphère oxydante (comme l'air) et/ou dans le cas où le support 11 ne présente pas de propriétés barrières satisfaisantes vis-à-vis de la diffusion des éléments constituant la couche de nucléation 20. Une telle couche amorphe peut par exemple être déposée par PVD ou par CVD ou ALD assisté ou non par plasma, ou encore formée par recuit thermique réactif du substrat (i.e. sous atmosphère oxydante ou nitrurante).

Alternativement, la surface du support polycrystallin 11 peut être rendue amorphe par un traitement plasma.

Si le substrat 10 n'est pas thermiquement stable jusqu'à la température la plus élevée du procédé (par exemple, si le substrat risque de cristalliser à haute température ou qu'il est déjà polycristallin mais présente un risque de modification de la densité et/ou de la morphologie d'au moins une partie des domaines cristallins dont il est constitué au cours du procédé), une étape de recuit thermique peut être appliquée afin de stabiliser le substrat 10. De préférence, la température choisie sera idéalement supérieure à la température la plus élevée utilisée lors des étapes suivantes du procédé.

Si la surface du substrat 10 a une rugosité trop élevée, cette dernière pourra être diminuée par un polissage, par exemple mécano-chimique (CMP).

Le substrat 10 peut être gravé localement.

Lors de l'étape b), on forme une couche mince de nucléation 20. La couche de nucléation 20 peut être également appelée couche d'ensemencement, couche de germination ou encore couche de texturation.

La couche de nucléation 20 est à base d'un ou plusieurs dichalcogénures de métaux de transition (aussi connus sous l'acronyme TMD ou TMDC pour « transition metal dichalcogenide ») ou à base d'un de leurs alliages.

De préférence, la couche de nucléation 20 a pour formule générale :

MSₓ

avec M le tungstène, le molybdène, ou un de leurs alliages,
x allant de 1,4 à 2,2 et, de préférence, de 1,8 à 2,1 et, encore plus préférentiellement, x étant égal à 2.

Il est à noter que ces variations de x ne remettent pas en cause la nature cristallographique de la couche de nucléation MS₂, et peuvent être simplement liées à des défauts structuraux localisés, à la composition des bordures de domaines cristallins ou des joints de grains, ou encore à la manière dont la couche de nucléation est liée avec la surface du substrat.

Encore plus préférentiellement, la couche de nucléation 20 est en MoSₓ ou en WSₓ.

L'alliage peut comprendre, par exemple, jusqu'à 50% atomique d'un ou plusieurs éléments additionnels. On choisira le ou les éléments additionnels de sorte que le paramètre de maille ne soit pas altéré de manière critique selon les axes a et b. Ces éléments additionnels peuvent inclure, de manière non limitative, des métaux de transition (tels que ceux des colonnes 4, 5 et 6 du tableau périodique), comme par exemple le vanadium, le niobium, le tantale, le titane ou le chrome. Par exemple, M peut être un alliage de molybdène et de tungstène pouvant contenir l'inclusion de métaux comme le vanadium ou le niobium.

Des impuretés peuvent également être présentes dans la couche de nucléation 20. Les impuretés peuvent provenir, par exemple, de la diffusion de métaux ou d'hétéroatomes du substrat 10. Les impuretés sont, en particulier, présentes en profondeur dans la couche de nucléation, notamment à l'interface du substrat 10 et de la couche de nucléation 20. Par exemple, une couche de MoS₂ de 2 nm formée sur du SiNₓ amorphe peut être nitrurée à l'interface SiNₓ/MoS₂. La surface de la couche de nucléation 20 sur laquelle va croître la couche d'AIN 30 est préservée.

Des dopants tels que l'azote, le phosphore, l'arsenic ou l'antimoine peuvent être introduits par implantation ou recuit réactif de la couche de nucléation 20. De la même manière que pour les éléments additionnels pouvant être associés au métal M, la quantité de ces éléments dopants ne devra pas altérer de manière critique le paramètre de maille de la couche de nucléation 20 de MS₂ selon les axes a et b.

La couche de nucléation 20 est formée de domaines cristallins dont les plans de base (002) sont parallèles à la surface du substrat 10, i.e. au plan (a, b). Les domaines cristallins ont une orientation aléatoire dans le plan (a, b) formé par la surface du substrat (figure 3).

Avantageusement, les cristaux de la couche de MS₂ ont une plus grande dimension comprise entre 1 et 100 nm, de préférence entre 5 et 50 nm.

L'épaisseur de la couche de nucléation 20 va de 0,6 nm (soit l'équivalent d'une monocouche, i.e. un feuillet unique de MS₂) à 50 nm, et de préférence de 0,6 à 12 nm, et encore plus préférentiellement de 0,6 nm à 8 nm.

Au-delà de quelques dizaines de nanomètres, par exemple au-delà de 20nm ou de 50nm, voire au-delà de 80nm pour certains substrats, les plans de base (002) des cristaux formant la couche de nucléation 20 de MS₂ ont tendance à ne plus être strictement parallèles à la surface du substrat et ne conviennent donc pas à la croissance d'une couche 30 d'AIN hautement texturé. La désorientation augmente avec l'épaisseur et dépend du substrat. D'une manière générale, plus la couche de nucléation 20 de MS₂ est fine, meilleure sera la texturation de la couche 30 d'AIN. On choisira l'épaisseur de la couche 20 de MS₂ en fonction de la nature du substrat 10 et de l'application visée.

La couche de nucléation peut être déposée par dépôt chimique en phase vapeur (CVD pour « Chemical Vapor Deposition »), par dépôt chimique en phase vapeur par couches atomiques (ALD pour « Atomic Layer Deposition »), par dépôt physique en phase vapeur (PVD pour « Physical Vapor Deposition ») ou par pulvérisation cathodique (« RF sputtering »).

La croissance de la couche de nucléation 20 peut être directe ou indirecte.

Selon une première variante de réalisation, la croissance de la couche de nucléation 20 est directe, c'est-à-dire qu'une seule étape suffit pour obtenir une couche de MSₓ avec x égal à 2 (figure 1A).

Par exemple, une telle croissance peut être réalisée en mettant en œuvre ces méthodes de dépôt à des températures suffisamment élevées pour permettre la cristallisation du composé MS₂ permettant la formation de la couche de nucléation 20 (typiquement supérieure à 500 °C).

Selon une deuxième variante de réalisation, représentée sur les figures 1B et 1C, la croissance de la couche de nucléation 20 est indirecte, c'est-à-dire que l'étape de croissance est réalisée en plusieurs étapes (au moins deux).

Typiquement, ces différentes étapes consistent successivement à :
- déposer une couche mince 21 contenant au moins le métal ou les métaux de transition de la couche de nucléation 20 finale,
- réaliser un ou plusieurs post-traitements conduisant à la formation d'une couche de nucléation 20 de formule MS₂ possédant des propriétés cristallines satisfaisantes.

Selon une première alternative de croissance indirecte, la couche mince 21 déposée contient à la fois le métal ou les métaux de transition et le soufre, avec un rapport atomique soufre/métal (noté S/M) supérieur ou égal à 2 (i.e. x est supérieur ou égal à 2). Une telle couche est, par exemple, obtenue lorsque la température lors du dépôt n'est pas suffisamment élevée pour permettre la cristallisation du composé MS₂ permettant la formation de la couche de nucléation 20 (typiquement inférieure à 450°C), et en présence de composés riches en soufre (par exemple le soufre élémentaire, les polysulfures, ou le 1,2-éthanedithiol).

Le post-traitement consiste à réaliser un recuit thermique dans des conditions inertes (sous ultravide ou gaz inerte par exemple) pour simultanément provoquer la cristallisation du composé MS₂, et évaporer le soufre en excès.

Les températures de recuit vont, avantageusement, de 450°C à 1200°C, préférentiellement de 750°C à 1000°C, et encore plus préférentiellement de 750°C à 950°C. La durée d'un recuit à une température supérieure à 950°C sera suffisamment courte pour ne pas endommager la couche de nucléation 20. La durée du recuit sera choisie en fonction, non seulement, de la température mais aussi de la nature du recuit (recuit thermique standard, traitement thermique rapide (RTP) ou recuit sous faisceau laser).

Selon une deuxième alternative de croissance indirecte, la couche mince 21 déposée :
- ne contient pas de soufre (par exemple la couche mince déposée 21 est un oxyde, un nitrure, un séléniure ou un oxysulfure du métal ou des métaux M), ou
- contient une quantité insuffisante de soufre : le rapport atomique S/M étant strictement inférieur à 2.

Selon cette deuxième alternative de croissance indirecte, le post-traitement est un recuit thermique réalisé en présence d'un élément contenant du soufre pour pouvoir former une couche de nucléation 20 présentant des propriétés cristallines satisfaisantes. Par exemple, cette étape est réalisée sous un flux d'hydrogène sulfuré (H₂S) ou d'un composé organosoufré, avantageusement dilués dans un gaz inerte, ou en présence de soufre élémentaire.

Selon un mode de réalisation particulier, de l'hydrogène peut être ajouté afin de limiter la formation de carbone (issu de la décomposition thermique des composés organosoufrés) ou de soufre élémentaire (issu de la polymérisation de l'hydrogène sulfuré).

Le composé organosoufré peut être choisi parmi les thiols, les polysulfures ou les dérivés de type silathianes (tels que l'hexaméthyldisilathiane).

On choisira, selon une première variante avantageuse, des composés organosoufrés ayant des chaînes aliphatiques courtes (typiquement possédant de 1 à 4 atomes de carbone).

Selon un mode de réalisation particulier, le composé soufré peut être dépourvu de carbone. On choisira, avantageusement, un composé volatil comme H₂S, H₂S₂ ou S₂Cl₂. L'utilisation de ce type de composés soufrés permet notamment d'éviter la contamination de la couche de nucléation par du carbone.

Les températures lors de la sulfuration vont, par exemple, de 150°C à 1200°C, préférentiellement de 350°C à 750°C. Cette étape de sulfuration peut être suivie d'une étape de recuit thermique sous atmosphère inerte. Les conditions du recuit thermique sont, par exemple, celles décrites pour la première alternative de la croissance indirecte.

Une légère variation de la stœchiométrie de la couche de nucléation 20 ou de la couche 21 après sulfuration (i.e. MSₓ avec x < 2) peut être liée aux états d'interface avec le substrat ou à la présence de défauts structuraux, comme évoqué précédemment, mais également à la formation d'une couche superficielle d'oxyde, par exemple lors de son exposition à l'air ambiant si elle n'a pas été déposée, sulfurée, ou recuite à une température suffisamment élevée pour être stable à l'air (i.e. T° < 650°C). Dans le cas où cette couche MSₓ ne contient pas d'autres métaux que le molybdène et le tungstène, ce problème d'oxydation superficielle peut être éliminé par un simple recuit thermique sous atmosphère inerte à une température supérieure à 650°C, ce qui permet l'élimination des oxydes de molybdène et/ou de tungstène par évaporation et l'obtention d'une couche mince de nucléation 20 de MS₂ dépourvue d'oxygène et possédant des propriétés cristallines satisfaisantes.

Selon un mode de réalisation particulier, non représenté, une couche mince d'encapsulation peut être déposée sur la couche mince 20 ou 21, pour préserver son intégrité lorsque le recuit thermique final est réalisé à des températures particulièrement élevées (supérieures à 950°C). Avant le dépôt de cette couche d'encapsulation il est nécessaire de s'assurer que le ratio S/M au sein de la couche mince 20 ou 21 est le plus proche possible de 2 par l'application d'une séquence de sulfuration et/ou de recuit adaptée, une quantité de soufre trop élevée pouvant conduire à la délamination de la couche d'encapsulation, et une quantité trop faible à la formation d'une couche MSₓ ne présentant pas la structure attendue.

La couche d'encapsulation est constituée d'un matériau chimiquement inerte vis-à-vis de la couche de nucléation 20 à la température utilisée pour le recuit. À titre illustratif et non limitatif, la couche d'encapsulation peut être un oxyde de métal (Al₂O₃, SiO₂, TiO₂, ZrO₂, HfO₂, VO₂, Ta₂O₅) ou un nitrure de métal (AlN, SiNₓ, TiNₓ, ZrNₓ, HfNₓ, VNₓ, TaNₓ).

Cette couche d'encapsulation est ensuite éliminée sélectivement avant le dépôt de la couche d'AIN, par exemple par un procédé de gravure humide non oxydant. La solution de gravure comprend, par exemple, de l'acide fluorhydrique, de la soude, de la potasse ou de l'ammoniaque.

Lors de l'étape c), on forme la couche 30 de nitrure d'aluminium texturé.

La couche 30 d'AIN présente une structure hexagonale de type wurtzite et possède une structure colonnaire composée de cristaux rigoureusement orientés dans la même direction selon l'axe c orthogonal au plan (a, b) formé par la surface du substrat. Les plans cristallins 002 des cristaux d'AIN constituant la couche 30 sont rigoureusement parallèles au plan (a, b), ainsi qu'aux plans 002 des domaines cristallins constituant la couche de nucléation 20 de MS₂.

Le degré de texturation peut être estimée, par exemple, par diffraction des rayons X à l'aide d'une mesure de courbe d'oscillation (« rocking curve ») obtenue en faisant varier la position angulaire omega autour de la position de Bragg du plan 002 de l'AIN. La largeur à mi-hauteur (FWHM) du pic obtenu permet de quantifier la texturation (autrement dit le degré de désorientation des cristaux) de la couche d'AIN.

Par hautement texturé (c'est-à-dire présentant une faible désorientation des cristaux), on entend que la largeur à mi-hauteur de la courbe d'oscillation (« rocking curve ») du plan 002 de l'AIN est inférieure à 2°, de préférence inférieure à 1° et encore plus préférentiellement inférieure à 0,5° pour des couches d'AIN dont l'épaisseur est supérieure à 50 nm.

Le dépôt de la couche d'AIN est, de préférence, réalisé à une température comprise entre la température ambiante (typiquement 20°C) et 400°C, de préférence entre 300°C et 350°C, ce qui permet de ne pas endommager la couche de MS₂ et évite ainsi de générer des défauts dans la couche d'AIN.

Le dépôt de la couche texturée 30 d'AIN sur la couche de nucléation 20 de MS₂ peut être mis en œuvre en utilisant diverses techniques comme la PVD, la pulvérisation cathodique, le dépôt par laser pulsé (PLD), la CVD ou l'ALD. Les paramètres de dépôt et la température seront choisis de manière à former une couche 30 d'AIN cristallin sous sa forme hexagonale (wurtzite).

De préférence, la couche 30 d'AIN est déposée par PVD. Ce mode de réalisation est particulièrement avantageux pour des applications RF, car cette technique de dépôt permet de former des couches épaisses (généralement d'épaisseur supérieure à 100 nm) en peu de temps.

De préférence, l'épaisseur de la couche 30 d'AIN va de 1 nm à quelques microns et encore plus préférentiellement de 1 nm à 1 µm. Selon les applications visées, on pourra choisir une faible épaisseur, par exemple, de 1 nm à 100 nm ou une forte épaisseur, par exemple de 100 nm à 1 µm.

Dans une variante de réalisation particulièrement avantageuse, l'épaisseur de la couche d'AIN est comprise entre 1nm et 300nm. De préférence, l'épaisseur est inférieure ou égale à 200nm et encore plus préférentiellement inférieure ou égale à 100nm. De telles épaisseurs évitent la délamination de l'empilement AlN/MoS₂ du substrat.

Le stress intrinsèque dans la couche 30 d'AIN joue un rôle critique dans sa tenue mécanique. Des valeurs de contrainte élevées peuvent, non seulement, provoquer la délamination de la couche 30 d'AIN en raison de l'absence de liaisons covalentes entre chaque feuillet constituant la couche de nucléation 20 en MS₂, ainsi qu'aux interfaces entre la couche de nucléation 20 et les matériaux situés de part et d'autre de cette couche (i.e. les interfaces substrat/MS₂ d'une part et MS₂/AlN d'autre part), mais peuvent également avoir un impact négatif sur la texture de la couche 30 d'AIN en raison de la formation de dislocations.

Selon un mode de réalisation particulier, une polarisation (bias) peut être appliquée sur le substrat 10 pendant le dépôt de la couche 30 d'AIN, notamment dans le cas d'un dépôt par PVD, afin de diminuer le stress mécanique au sein de la couche 30 d'AIN et par conséquent pouvoir augmenter l'épaisseur critique à laquelle la couche 30 d'AIN va commencer à délaminer. Cette polarisation peut être appliquée, avantageusement, après le dépôt de quelques nanomètres d'AIN afin d'éviter d'endommager la surface de la couche de nucléation 20.

Selon une autre variante de réalisation, on effectue, préalablement au dépôt de la couche 30 d'AIN, une gravure localisée de la couche 20 de MS₂, de manière à rendre localement accessibles certaines zones du substrat 10. Ces zones du substrat 10 non recouvertes par la couche 20 de MS₂ servent de point d'ancrage à la couche 30 d'AIN. La délamination de la couche 30 d'AIN peut être ainsi évitée en améliorant l'adhésion entre l'empilement AlN/MS₂ et le substrat 10. La gravure localisée peut, par exemple, être réalisée par des techniques standard de lithographie.

La couche 30 d'AIN peut contenir des agents dopants tels que des métaux de transition ou des terres rares, afin d'ajuster les propriétés piézoélectriques de l'AIN et/ou modifier ses paramètres de maille, par exemple pour permettre de diminuer le désaccord de maille entre l'AIN et le MS₂ constituant la couche de nucléation. De tels agents dopants peuvent être, par exemple, choisis seuls ou en combinaison, parmi le groupe comprenant le chrome, le molybdène, le tungstène, le scandium, l'yttrium et les autres lanthanides, dans des proportions n'induisant pas une altération des paramètres de maille de l'AIN supérieure à ±0,05 nm selon les axes a et b.

Selon un mode de réalisation particulier, on répète cycliquement les étapes b) et c) pour obtenir une alternance de couches de nucléation 20 de MS₂ et de couches 30 d'AIN texturé. Ce mode de réalisation particulier peut, par exemple, permettre de relaxer les contraintes au sein de chaque couche 30 d'AIN et ainsi limiter la formation de dislocations et/ou la délamination des couches 30 d'AIN.

L'invention concerne également un empilement susceptible d'être obtenu par le procédé tel que défini précédemment comprenant, et de préférence constitué successivement par (figure 2):
- une couche mince (30) d'AIN texturé,
- une couche de nucléation polycristalline (20) de MS₂.

L'empilement peut comprendre, en outre, le substrat 10 tel que décrit précédemment.

L'orientation des domaines cristallins est aléatoire dans un plan (a, b) parallèle à l'empilement.

La couche mince 30 d'AIN texturée seule ou avec la couche de nucléation polycristalline 20, sous la forme d'un empilement, est particulièrement intéressante pour la fabrication de dispositifs microélectroniques et/ou électroniques.

Bien que cela ne soit aucunement limitatif, l'invention trouve des applications dans de nombreux domaines, et en particulier, elle peut être utilisée dans le domaine des dispositifs RF et plus particulièrement des filtres RF, des diodes électroluminescentes (LEDs), des résonateurs acoustiques ou de tout autre dispositif nécessitant l'utilisation une membrane piézoélectrique, ayant notamment une épaisseur inférieure à 100 nm. Elle peut être également utilisée de manière indirecte, telle que déposée ou après transfert sur un autre substrat. Dans le cas d'un transfert impliquant un retournement de l'empilement AlN/MS₂, la couche de nucléation 20 de MS₂ peut être éliminée ou conservée. Elle peut alors servir de couche de passivation pour l'AIN, ou de couche de nucléation pour la croissance d'un autre matériau.

### Exemples illustratifs et non limitatifs de modes particuliers de réalisation :

Dans cet exemple, le substrat 10 est une plaque (« wafer ») de silicium 11 recouverte d'une couche amorphe 12 de SiO₂ de 500 nm d'épaisseur obtenue par oxydation thermique.Une couche mince 20 de MoS₂ de 2 nm d'épaisseur (soit environ 3 monocouches) est obtenue par ALD à 100°C en injectant alternativement deux précurseurs : Mo(NMe₂)₄ et le 1,2-éthanedithiol. Les paramètres utilisés sont, par exemple, ceux décrits dans le document EP 2 899 295 A1. Le dépôt obtenu est ensuite sulfuré à 450°C pendant 5 min sous un flux d'azote de 200 NmL/min contenant 4% d'hydrogène et 0,5 torr de vapeur de disulfure de di-tert-butyle, suivi d'un traitement thermique rapide à 950°C sous flux d'argon pendant 5 min.

Une couche 30 d'AIN de 100 nm d'épaisseur est finalement déposée sur la couche 20 de MoS₂ par pulvérisation cathodique (puissance RF: 2 KW, température du substrat: 350°C).

Une observation STEM de l'échantillon en coupe transversale confirme la présence des trois couches SiO_{2/}MoS₂/AlN et la croissance colonnaire de la couche 30 d'AIN (figures 4A, 4B + schéma de la figure 4C). L'observation des interfaces SiO₂/MoS₂/AlN à très haute résolution confirme la croissance épitaxiale des cristaux d'AIN sur les domaines cristallins de MoS₂ de la couche de nucléation 20, ainsi que l'absence de diffusion à l'interface AlN/MoS₂. Une légère diffusion du molybdène est observée dans le substrat de SiO₂, mais n'affecte pas la qualité de la monocouche de surface du MoS₂ qui est celle induisant la texturation de l'AIN.

La texture de la couche 30 d'AIN est évaluée par diffraction des rayons X à l'aide d'une mesure de courbe d'oscillation (« rocking curve ») obtenue en faisant varier la position angulaire omega autour de la position de Bragg du plan 002 de l'AIN. La courbe (omega scan) obtenue est représentée sur la figure 5.

La valeur de la largeur à mi-hauteur (FWHM) de la courbe d'oscillation pour cette couche de 100 nm d'AIN sur MoS₂ est de 0,43°, ce qui est proche des meilleures valeurs habituellement obtenues avec des couches d'AIN dont la croissance a été réalisée à très haute température sur des substrats de saphir monocristallin.

À titre de comparaison, une couche d'AIN d'épaisseur similaire (100 nm) a été déposée, avec les mêmes paramètres :
- directement sur du SiO₂, ce qui conduit à une largeur à mi-hauteur de la courbe d'oscillation de 4,18°,
- sur une électrode de molybdène très texturée et orientée 110 (qui est une référence pour la fabrication de filtres RF), ce qui conduit à une largeur à mi-hauteur de la courbe d'oscillation de 2,57° (Fig. 5).

L'influence de l'épaisseur de la couche 30 d'AIN sur sa texturation a été évaluée pour des épaisseurs comprises entre 5 nm et 100 nm, tous les autres paramètres (substrat et nature de la couche 20 de MoS₂) étant conservés identiques (figure 6). Les résultats obtenus indiquent des valeurs de largeur à mi-hauteur de la courbe d'oscillation inférieures à 1° pour des couches d'AIN de seulement 25 nm d'épaisseur, et inférieures à 0,5° pour des couches d'AIN d'épaisseurs supérieures à 50 nm, révélant une capacité du procédé objet de l'invention à texturer des couches d'AIN extrêmement minces (typiquement inférieures à 100 nm) bien supérieure à ce qui a été reporté jusqu'à présent dans la littérature.

## Revendications

1. Procédé pour fabriquer une couche mince (30) d'AIN texturé comprenant les étapes successives suivantes :
a) fourniture d'un substrat (10), ayant une surface amorphe,
b) formation d'une couche de nucléation polycristalline (20) de MS₂ avec M=Mo, W ou un de leurs alliages, sur la surface amorphe du substrat (10), la couche de nucléation (20) polycristalline étant constituée de domaines cristallins dont les plans de base (002) sont parallèles à la surface amorphe du substrat (10), les domaines cristallins étant orientés aléatoirement dans un plan (a, b) formé par la surface amorphe du substrat (10),
c) dépôt de nitrure d'aluminium sur la couche de nucléation (20), conduisant à la formation d'une couche mince (30) d'AIN texturé.

2. Procédé selon la revendication 1, **caractérisé en ce que** l'alliage M de la couche de nucléation (20) de MS₂ contient jusqu'à 50% atomique d'un ou plusieurs éléments additionnels choisis parmi les métaux de transition.

3. Procédé selon l'une des revendications 1 et 2, **caractérisé en ce que** la couche de nucléation (20) a une épaisseur allant de 0,6 nm à 50 nm, et de préférence de 0,6 nm à 8 nm.

4. Procédé selon l'une des revendications 1 à 3, **caractérisé en ce que** l'étape b) est réalisée à une température autorisant la formation d'une couche de nucléation polycristalline (20) de MS₂ en une seule étape.

5. Procédé selon l'une quelconque des revendications 1 à 3, **caractérisé en ce que** l'étape b) est réalisée selon les étapes successives suivantes :
- dépôt d'une couche de MSₓ avec x supérieur ou égal à 2,
- recuit de la couche de MSₓ sous atmosphère inerte à une température allant de 450°C à 1200°C et de préférence de 750°C à 950°C, de manière à former une couche de nucléation polycristalline (20) de MS₂.

6. Procédé selon l'une des revendications 1 à 3, **caractérisé en ce que** l'étape b) est réalisée selon les étapes successives suivantes :
- dépôt d'une couche mince contenant M sous forme élémentaire ou associé à un ou plusieurs hétéroatomes,
- recuit thermique réactif en présence d'un composé volatil contenant du soufre à une température allant de 150°C à 1200°C et, de préférence, allant de 350°C à 750°C,
- éventuellement, recuit sous atmosphère inerte à une température allant de 450°C à 1200°C et, de préférence, de 750°C à 950°C, de manière à former une couche de nucléation polycristalline (20) de MS₂.

7. Procédé selon l'une quelconque des revendications précédentes, **caractérisé en ce que** la couche de nucléation polycristalline (20) de MS₂ contient un élément dopant tel que l'azote, le phosphore, l'arsenic ou l'antimoine.

8. Procédé selon l'une quelconque des revendications précédentes, **caractérisé en ce que** l'étape c) de dépôt de la couche mince (30) d'AIN texturé est réalisée par dépôt physique en phase vapeur ou pulvérisation cathodique.

9. Procédé selon l'une quelconque des revendications précédentes, **caractérisé en ce que** la couche mince (30) d'AIN texturé a une épaisseur allant de 1 nm à 1 µm, et de préférence comprise entre 1nm et 300nm.

10. Procédé selon l'une quelconque des revendications précédentes, **caractérisé en ce que** la couche mince (30) d'AIN texturé contient des éléments dopants tels que le chrome, le molybdène, le tungstène, le scandium, l'yttrium ou un élément des lanthanides.

11. Procédé selon l'une quelconque des revendications précédentes, **caractérisé en ce que** la surface amorphe du substrat (10) a une rugosité inférieure à 5nm, de préférence inférieure à 1nm et encore plus préférentiellement inférieure à 0,3nm.

12. Procédé selon l'une quelconque des revendications 1 à 11, **caractérisé en ce qu'**il comporte une étape additionnelle, ultérieure à l'étape c), au cours de laquelle on retire un empilement comprenant la couche de nucléation polycristalline (20) MS₂ et la couche mince (30) d'AIN texturé du substrat (10).

13. Empilement comprenant :
- une couche mince (30) d'AIN texturé, obtenue par le procédé selon l'une des revendications 1 à 12,
- une couche de nucléation polycristalline (20) de MS₂ avec M=Mo, W ou un de leurs alliages, la couche de nucléation polycristalline (20) étant constituée de domaines cristallins dont les plans de base (002) sont parallèles à l'empilement, l'orientation des domaines cristallins dans un plan (a, b) formé par l'empilement étant aléatoire .

14. Empilement tel que défini dans la revendication 13, comprenant, en outre, un substrat (10) ayant une surface amorphe, la couche de nucléation polycristalline (20) de MS₂ étant disposée entre le substrat (10) et la couche mince (30) d'AIN texturé.

15. Dispositif microélectronique, par exemple un dispositif radiofréquence, une LED, un dispositif de puissance ou une membrane piézoélectrique comprenant une couche mince (30) d'AIN texturé obtenue par le procédé selon l'une des revendications 1 à 12 ou comprenant un empilement tel que défini dans l'une des revendications 13 et 14.

## Patentansprüche

1. Verfahren zur Herstellung einer dünnen Schicht (30) aus strukturiertem AIN, das folgende aufeinanderfolgende Schritte umfasst:
a) Bereitstellung eines Substrats (10), das eine amorphe Oberfläche aufweist,
b) Bildung einer polykristallinen Keimbildungsschicht (20) aus MS₂ mit M=Mo, W oder einer ihrer Legierungen auf der amorphen Oberfläche des Substrats (10), wobei die polykristalline Keimbildungsschicht (20) aus kristallinen Bereichen besteht, deren Basisebenen (002) parallel zur amorphen Oberfläche des Substrats (10) sind, wobei die kristallinen Bereiche zufällig in einer Ebene (a, b) ausgerichtet sind, die von der amorphen Oberfläche des Substrats (10) gebildet wird,
c) Ablagerung von Aluminiumnitrid auf der Keimbildungsschicht (20), wobei es zur Bildung einer dünnen Schicht (30) aus strukturiertem AIN kommt.

2. Verfahren nach Anspruch 1, **dadurch gekennzeichnet, dass** die Legierung M der Keimbildungsschicht (20) aus MS₂ bis zu 50 % atomar eines oder mehrerer Zusatzelemente enthält, die aus den Übergangsmetallen ausgewählt sind.

3. Verfahren nach einem der Ansprüche 1 und 2, **dadurch gekennzeichnet, dass** die Keimbildungsschicht (20) eine Dicke von 0,6 nm bis 50 nm und vorzugsweise von 0,6 nm bis 8 nm aufweist.

4. Verfahren nach einem der Ansprüche 1 bis 3, **dadurch gekennzeichnet, dass** der Schritt b) bei einer Temperatur durchgeführt wird, die die Bildung einer polykristallinen Keimbildungsschicht (20) aus MS₂ in einem einzigen Schritt zulässt.

5. Verfahren nach einem der Ansprüche 1 bis 3, **dadurch gekennzeichnet, dass** der Schritt b) nach folgenden aufeinanderfolgenden Schritten durchgeführt wird:
- Ablagerung einer Schicht aus MSₓ mit x größer oder gleich 2,
- Glühen der Schicht aus MSₓ unter inerter Atmosphäre bei einer Temperatur von 450 °C bis 1200 °C und vorzugsweise von 750 °C bis 950 °C, sodass eine polykristalline Keimbildungsschicht (20) aus MS₂ entsteht.

6. Verfahren nach einem der Ansprüche 1 bis 3, **dadurch gekennzeichnet, dass** der Schritt b) nach folgenden aufeinanderfolgenden Schritten durchgeführt wird:
- Ablagerung einer dünnen Schicht, die M in elementarer Form oder in Verbindung mit einem oder mehreren Heteroatomen enthält,
- reaktives thermisches Glühen in Gegenwart einer flüchtigen Verbindung, die Schwefel enthält, bei einer Temperatur von 150°C bis 1200°C und vorzugsweise von 350 °C bis 750 °C,
- eventuell unter inerter Atmosphäre bei einer Temperatur von 450 °C bis 1200 °C und vorzugsweise von 750 °C bis 950 °C geglüht, um eine polykristalline Keimbildungsschicht (20) aus MS₂ zu bilden.

7. Verfahren nach einem der vorhergehenden Ansprüche, **dadurch gekennzeichnet, dass** die polykristalline Keimbildungsschicht (20) aus MS₂ ein Dotierelement wie Stickstoff, Phosphor, Arsen oder Antimon enthält.

8. Verfahren nach einem der vorhergehenden Ansprüche, **dadurch gekennzeichnet, dass** der Schritt c) der Ablagerung der dünnen Schicht (30) aus strukturiertem AIN durch physikalische Dampfphasenablagerung oder kathodisches Sputtern erfolgt.

9. Verfahren nach einem der vorhergehenden Ansprüche, **dadurch gekennzeichnet, dass** die dünne Schicht (30) aus strukturiertem AIN eine Dicke von 1 nm bis 1 µm und vorzugsweise von 1 nm bis 300 nm aufweist.

10. Verfahren nach einem der vorhergehenden Ansprüche, **dadurch gekennzeichnet, dass** die dünne Schicht (30) aus strukturiertem AIN Dotierelemente wie Chrom, Molybdän, Wolfram, Scandium, Yttrium oder ein Lanthanidelement enthält.

11. Verfahren nach einem der vorhergehenden Ansprüche, **dadurch gekennzeichnet, dass** die amorphe Oberfläche des Substrats (10) eine Rauheit von weniger als 5 nm, vorzugsweise weniger als 1 nm und noch bevorzugter weniger als 0,3 nm aufweist.

12. Verfahren nach einem der Ansprüche 1 bis 11, **dadurch gekennzeichnet, dass** es einen zusätzlichen Schritt nach Schritt c) umfasst, bei dem eine Stapelung, die die polykristalline Keimbildungsschicht (20) aus MS₂ und die dünne Schicht (30) aus strukturiertem AIN vom Substrat (10) umfasst, entfernt wird.

13. Stapelung umfassend:
- eine dünne Schicht (30) aus strukturiertem AIN, die durch das Verfahren nach einem der Ansprüche 1 bis 12 erhalten wird,
- eine polykristalline Keimbildungsschicht (20) aus MS₂ mit M=Mo, W oder einer ihrer Legierungen, wobei die polykristalline Keimbildungsschicht (20) aus kristallinen Bereichen besteht, deren Basisebenen (002) parallel zur Stapelung sind, wobei die Ausrichtung der kristallinen Bereiche in einer durch die Stapelung gebildeten Ebene (a, b) zufällig ist.

14. Stapelung gemäß Anspruch 13, ferner umfassend ein Substrat (10) mit einer amorphen Oberfläche, wobei die polykristalline Keimbildungsschicht (20) aus MS₂ zwischen dem Substrat (10) und der dünnen Schicht (30) aus strukturiertem AIN angeordnet ist.

15. Mikroelektronikvorrichtung, beispielsweise eine Funkfrequenzvorrichtung, eine LED, eine Leistungsvorrichtung oder eine piezoelektrische Membran, die eine dünne Schicht (30) aus strukturiertem AIN umfasst, die durch das Verfahren nach einem der Ansprüche 1 bis 12 gewonnen wird oder umfassend eine Stapelung gemäß einem der Ansprüche 13 und 14.

## Claims

1. Method for manufacturing a thin layer (30) of textured AIN comprising the following successive steps:
a) providing a substrate (10) having an amorphous surface,
b) forming a polycrystalline nucleation layer (20) of MS₂ with M = Mo, W or one of the alloys thereof, on the amorphous surface of the substrate (10), the polycrystalline nucleation layer (20) consisting of crystalline domains, the (002) base planes of which are parallel to the amorphous surface of the substrate (10), the crystalline domains being oriented randomly in an (a, b) plane formed by the amorphous surface of the substrate (10),
c) depositing aluminum nitride on the nucleation layer (20), leading to the formation of a thin layer (30) of textured AIN.

2. Method according to claim 1, **characterised in that** the alloy M of the nucleation layer (20) of MS₂ contains up to 50% atomic one or more additional elements chosen from transition metals.

3. Method according to one of claims 1 and 2, **characterised in that** the nucleation layer (20) has a thickness ranging from 0.6 nm to 50 nm, and preferably from 0.6 nm to 8 nm.

4. Method according to one of claims 1 to 3, **characterised in that** step b) is performed at a temperature allowing the formation of a polycrystalline nucleation layer (20) of MS₂ in a single step.

5. Method according to any one of claims 1 to 3, **characterised in that** step b) is performed in accordance with the following successive steps:
- depositing a layer of MSₓ with x greater than or equal to 2,
- annealing the layer of MSₓ under inert atmosphere at a temperature ranging from 450°C to 1200°C and preferably from 750°C to 950°C, so as to form a polycrystalline nucleation layer (20) of MS₂.

6. Method according to one of claims 1 to 3, **characterised in that** step b) is performed in accordance with the following successive steps:
- depositing a thin layer containing M in elementary form or associated with one or more heteroatoms,
- reactive thermal annealing in the presence of a volatile compound containing sulfur at a temperature ranging from 150°C to 1200°C, and preferably ranging from 350°C to 750°C,
- optionally, annealing under inert atmosphere at a temperature ranging from 450°C to 1200°C and preferably from 750°C to 950°C, so as to form a polycrystalline nucleation layer (20) of MS₂.

7. Method according to any one of preceding claims, **characterised in that** the polycrystalline nucleation layer (20) of MS₂ contains a doping element such as nitrogen, phosphorus, arsenic or antimony.

8. Method according to any one of preceding claims, **characterised in that** step c) of depositing the thin layer (30) of textured AIN is performed by physical vapor deposition or cathodic sputtering.

9. Method according to any one of preceding claims, **characterised in that** the thin layer (30) of textured AIN has a thickness ranging from 1 nm to 1 µm, and preferably between 1 nm and 300 nm.

10. Method according to any one of preceding claims, **characterised in that** the thin layer (30) of textured AIN contains doping elements such as chromium, molybdenum, tungsten, scandium, yttrium or a lanthanide element.

11. Method according to any one of preceding claims, **characterised in that** the amorphous surface of the substrate (10) has a roughness of less than 5 nm, preferably of less than 1 nm, and even more preferentially less than 0.3 nm.

12. Method according to any one of claims 1 to 11, **characterised in that** it includes an additional step, subsequent to step c), during which a stack comprising the polycrystalline nucleation layer (20) MS₂ and the thin layer (30) of textured AIN is removed from the substrate (10).

13. Stack comprising:
- a thin layer (30) of textured AIN, obtained by the method according to one of claims 1 to 12,
- a polycrystalline nucleation layer (20) of MS₂ with M = Mo, W or one of the alloys thereof, the polycrystalline nucleation layer (20) consisting of crystalline domains, the (002) base planes of which are parallel to the stack, the orientation of the crystalline domains in an (a, b) plane formed by the stack being random.

14. Stack as defined in claim 13, comprising furthermore a substrate (10) having an amorphous surface, the polycrystalline nucleation layer (20) of MS₂ being disposed between the substrate (10) and the thin layer (30) of textured AIN.

15. Microelectronic device, for example a radio-frequency device, a LED, a power device or a piezoelectric membrane comprising a thin layer (30) of textured AIN obtained by the method according to one of claims 1 to 12 or comprising a stack as defined in one of claims 13 and 14.
